# EUROPEAN PATENT APPLICATION

(11) **EP 1 780 739 A1**
(43) Date of publication of application: **02.05.2007**
(21) Application number: 05757796.7
(22) Date of filing: 06.07.2005
(51) Int. Cl.: H01H 17/00, H03H 17/02, H03H 17/06

(54) **THINNING FILTER AND TEST DEVICE**

(30) Priority: 07.07.2004 JP 2004201069
(71) Applicant: ADVANTEST CORPORATION, Nerima-ku, Tokyo 179-0071 (JP)
(72) Inventor: TAKAHASHI, Takeshi, c/o ADVANTEST CORPORATION, Tokyo 1790071 (JP)
(74) Representative: Pfenning, Meinig & Partner GbR
(86) International application number: PCT/JP2005/012470
(87) International publication number: WO 2006/004148

(57) **Abstract**

There is provided a thinning filter including a first thinning section for down-sampling input data, a first filter section for filtering the data down-sampled by the first thinning section to output the filtered data, and a second thinning section for further down-sampling the data filtered by the first filter section, in which the filter section further filters the data down-sampled by the second thinning section to output the filtered data. According to the present invention, it is possible to provide a thinning filter having a small circuit scale and a high operation rate and a test apparatus including the thinning filter.

## Description

### TECHNICAL FIELD

The present invention relates to a thinning filter and a test device. More particularly, the present invention relates to a thinning filter having a small circuit scale and a test device including the thinning filter. The present application claims priority from a Japanese Patent Application No. 2004-201069 filed on July 7, 2004, the contents of which are incorporated herein by reference.

### BACKGROUND ART

A thinning filter includes a low-pass filter and a down sampler. The low-pass filter is realized by, e.g., a finite impulse response filter, and includes a register for delaying input data, a multiplier for multiplying a filter coefficient by the input data, and an adder for adding a multiplication result. The down sampler is realized by, e.g., a register, and inputs an enable signal into the register every M input data to destroy M-1 input data every the M input data, disclosed, for example, in the following non-patent documents.

Non-patent document 1: "OCHI Hiroshi, A digital signal processing learned from simulation, CQ publishing company, July 1, 2001"
Non-patent document 2: "KIYA Hitoshi, A multi-rate signal processing, SHOKODO Co., Ltd., October 6, 1995".

### DISCLOSURE OF THE INVENTION

### PROBLEMS TO BE SOLBED BY THE INVENTION

In a conventional thinning filter, a multiplier circuit included in a finite impulse response filter occupies most of a thinning filter circuit. Therefore, it is necessary to reduce a circuit scale of the multiplier included in the finite impulse response filter in order to reduce a circuit scale of the thinning filter. However, since an operation rate falls down when reducing the number of multipliers and the number of multipliers should be increased to raise an operation rate, it has been difficult to realize both sides of reduction of a circuit scale of a thinning filter and enhancement of an operation rate.

Therefore, it is an object of the present invention to provide a test apparatus that can solve the foregoing problems. The above and other objects can be achieved by combinations described in the independent claims. The dependent claims define further advantageous and exemplary combinations of the present invention.

### MEANS FOR SOLVING THE PROBLEMS

According to the first aspect of the present invention, there is provided a thinning filter. The thinning filter includes: a first thinning section for down-sampling input data; a first filter section for filtering the data down-sampled by the first thinning section to output the filtered data; and a second thinning section for further down-sampling the data filtered by the first filter section, in which the first filter section further filters the data down-sampled by the second thinning section to output the filtered data.

The thinning filter may further include: a third thinning section for down-sampling the input data at the timing different from the timing at which the input data is down-sampled in the first thinning section; a second filter section for filtering the data down-sampled by the third thinning section with a filter coefficient different from a filter coefficient of the first filter section to output the filtered data; and a fourth thinning section for further down-sampling the data filtered by the second filter section, and the second filter section may further filter the data down-sampled by the fourth thinning section to output the filtered data.

The first thinning section and the second thinning section may down-sample the data with the same thinning rate. The thinning filter may further include an adder for adding the data output from the first filter section and the data output from the second filter section. The thinning filter may further include a delaying section for delaying the input data, and the third thinning section may down-sample the data delayed by the delaying section.

The first thinning section may acquire the input data and the data output from the second thinning section and insert the data output from the second thinning section between the data obtained by down-sampling the input data to supply the inserted data to the first filter section, and the second thinning section may acquire the data delayed by the delaying section and the data output from the fourth thinning section and insert the data output from the fourth thinning section between the data obtained by down-sampling the data delayed by the delaying section to supply the inserted data to the second filter section.

The first filter section may include: a first multiplier for multiplying a first filter coefficient by the data down-sampled by the first thinning section or the second thinning section to output the result; a second multiplier for multiplying a second filter coefficient by the data down-sampled by the first thinning section or the second thinning section to output the result; and an adder for adding the data output from the first multiplier and the data output from the second multiplier.

The first filter section may permit the change of filter coefficient, and filter the data down-sampled by the first thinning section or the second thinning section with a set filter coefficient to output the filtered data.

According to the second aspect of the present invention, there is provided a test apparatus that tests a device under test. The test apparatus includes: an analog-to-digital conversion section for sampling data output from the device under test to convert the sampled data into digital signal data; a thinning filter for down-sampling the data output from the analog-to-digital conversion section; and a quality deciding section for deciding the good or bad of the device under test based on the data down-sampled by the thinning filter, in which the thinning filter includes: a first thinning section for down-sampling the input data; a first filter section for filtering the data down-sampled by the first thinning section to output the filtered data; and a second thinning section for further down-sampling the data filtered by the first filter section, and the first filter section further filters the data down-sampled by the second thinning section to output the filtered data.

The summary of the invention does not necessarily describe all necessary features of the present invention. The present invention may also be a sub-combination of the features described above.

### EFFECT OF THE INVENTION

According to the present invention, it is possible to provide a thinning filter having a small circuit scale and a high operation rate and a test apparatus including the thinning filter.

### BRIEF DESCRIPTION OF THE DRAWINGS

Fig. 1 is a view exemplary showing a configuration of a test apparatus.
Fig. 2 is a view exemplary showing a configuration of a thinning filter.
Fig. 3 is a view showing the first example of a timing chart for the thinning filter.
Fig. 4 is a view showing the second example of a timing chart for the thinning filter.
Fig. 5 is a view showing the first alternative example of a configuration of an arithmetic section.
Fig. 6 is a view showing the second alternative example of a configuration of the arithmetic section.

### BEST MODE FOR CARRYING OUT THE INVENTION

The invention will now be described based on the preferred embodiments, which do not intend to limit the scope of the present invention, but exemplify the invention. All of the features and the combinations thereof described in the embodiment are not necessarily essential to the invention.

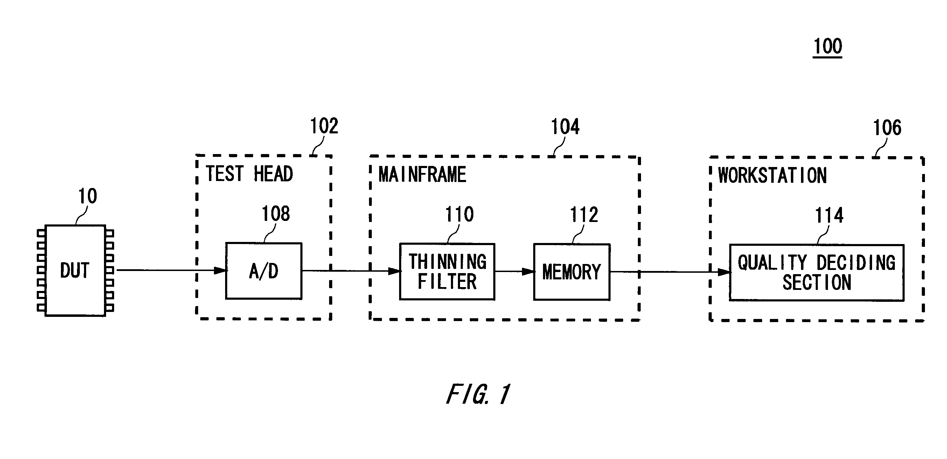

Fig. 1 is a view exemplary showing a configuration of a test apparatus 100 according to an embodiment of the present invention. The test apparatus 100 includes a test head 102, a mainframe 104, and a workstation 106. The test apparatus 100 measures a test signal output from a device under test (hereinafter, referred to as "DUT") 10 by means of the test head 102, performs a desired signal processing for the measured test signal by means of the mainframe 104, and analyzes the test signal by means of the workstation 106, in order to test the DUT 10.

The test head 102 has a plurality of test modules such as a test module for an analog test and a test module for a digital test. The test module for digital test includes an A/D 108 that is an example of an analog-to-digital conversion section of the present invention. The A/D 108 samples data output from the DUT 10 to convert it into digital signal data, and supplies the converted data to the mainframe 104.

The mainframe 104 has a thinning filter 110 and a memory 112, and the thinning filter 110 down-samples the data output from the A/D 108 and supplies it to the memory 112 to store it. The workstation 106 has a quality deciding section 114, and the quality deciding section 114 decides the good or bad of the DUT 10 based on the data down-sampled by the thinning filter 110 and stored on the memory. In this way, a failure of the DUT 10 is detected and thus the DUT 10 is destructed or preserved, based on the decision result by the quality deciding section 114.

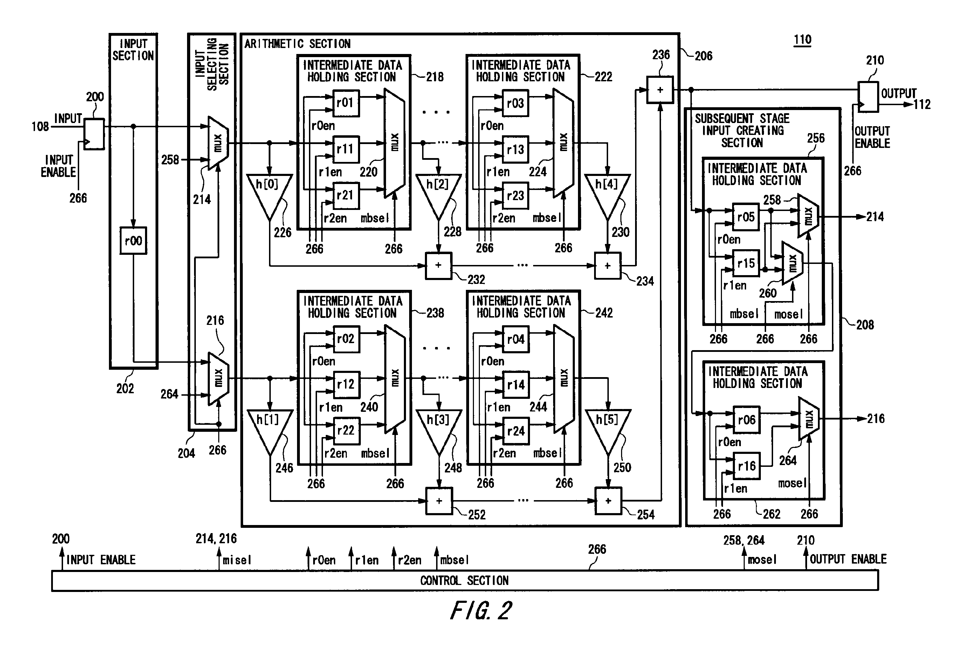

Fig. 2 is a view exemplary showing a configuration of the thinning filter 110 according to the present embodiment. The thinning filter 110 includes an input latch circuit 200, an input section 202, an input selecting section 204, an arithmetic section 206, a subsequent stage input creating section 208, an output latch circuit 210, and a control section 266. The input section 202 has a register r00. The input selecting section 204 has a multiplexer 214 and a multiplexer 216.

The arithmetic section 206 has intermediate data holding sections 218, 222, 238, and 242, multipliers 226, 228, 230, 246, 248, and 250, and adders 232, 234, 236, 252, and 254. The intermediate data holding section 218 includes registers r01, r11, and r21 and a multiplexer 220. The intermediate data holding section 238 includes registers r02, r12, and r22 and a multiplexer 240. The intermediate data holding section 222 includes registers r03, r13, and r23 and a multiplexer 224. The intermediate data holding section 242 includes registers r04, r14, and r24 and a multiplexer 244.

The subsequent stage input creating section 208 has intermediate data holding sections 256 and 262. The intermediate data holding section 256 includes registers r05 and r15 and multiplexers 258 and 260. The intermediate data holding section 262 includes registers r06 and r16 and a multiplexer 264.

In addition, the multiplexer 214, the multiplexer 258, the multiplexer 216, and the multiplexer 264 respectively are an example of a first thinning section, a second thinning section, a third thinning section, and a fourth thinning section of the present invention. Moreover, the intermediate data holding sections 218 and 222, the multipliers 226, 228, and 230, and the adders 232 and 234 are an example of a first filter section of the present invention. Moreover, the intermediate data holding sections 238 and 242, the multipliers 246, 248, and 250, and the adders 252 and 254 are an example of a second filter section of the present invention. Moreover, the register r00 is an example of a delaying section of the present invention.

In addition, in the present embodiment, thinning with a thinning rate of 1/8 is realized by repeating thinning with a thinning rate of 1/2 three times. However, a thinning filter of the present invention may realize a thinning rate of 1/M^{N} by repeating thinning with a thinning rate of 1/M by N times. Moreover, in the present embodiment, the thinning filter 110 has a polyphase structure with two phases. However, in another embodiment, the thinning filter may have a polyphase structure with three or more phases.

At first, it will be described about a brief description of an operation of the thinning filter 110. The data input from the input latch circuit 200 is thinned out by the multiplexer 214, and is filtered by the arithmetic section 206. Moreover, the data input from the input latch circuit 200 is delayed by the register r00 by one sample, and then is thinned out by the multiplexer 216 and is filtered by the arithmetic section 206. Then, the data thinned out and filtered by the multiplexer 214 and the data thinned out and filtered by the multiplexer 216 are added by the adder 236, and the added data is input into the subsequent stage input creating section 208.

Then, the data input into the subsequent stage input creating section 208 is further thinned out by the multiplexer 258, and is filtered by the arithmetic section 206. Moreover, the data input into the subsequent stage input creating section 208 is delayed by the register r06 by one sample, and then is further thinned out by the multiplexer 264 and is filtered by the arithmetic section 206. Then, the data thinned out and filtered by the multiplexer 258 and the data thinned out and filtered by the multiplexer 264 are added by the adder 236, and the added data is again input into the subsequent stage input creating section 208.

Then, the data input into the subsequent stage input creating section 208 is further thinned out by the multiplexer 258, and is filtered by the arithmetic section 206. Moreover, the data input into the subsequent stage input creating section 208 is delayed by the register r16 by one sample, and then is further thinned out by the multiplexer 264 and is filtered by the arithmetic section 206. Then, the data thinned out and filtered by the multiplexer 258 and the data thinned out and filtered by the multiplexer 264 are added by the adder 236, and the added data is output from the output latch circuit 210.

According to the present embodiment, it is possible to reduce the number of multipliers and adders without lowering an operation rate and thus to reduce a circuit scale of the thinning filter 110 by looping data to be thinned out and filtering the data more than once by means of the same multiplier and adder.

Next, it will be described about an operation of each component included in the thinning filter 110. The input latch circuit 200 supplies the data output from the A/D 108 to the input section 202 by being supplied with an input enable signal from the control section 266. Then, the input section 202 supplies the data input from the input latch circuit 200 to the multiplexer 214. Moreover, the register r00 delays the data input from the input latch circuit 200 by one sample to supply the delayed data to the multiplexer 216.

In the input selecting section 204, the multiplexer 214 down-samples the data input from the input section 202 to supply it to the intermediate data holding section 218 and the multiplier 226, based on a select signal (misel) supplied from the control section 266. Specifically, the multiplexer 214 acquires the data input through the input section 202 and the data output from the multiplexer 258, and alternately selects the data input through the input section 202 and the data output from the multiplexer 258 based on the select signal (misel) supplied from the control section 266, in order to supply the selected data to the intermediate data holding section 218 and the multiplier 226. In other words, the multiplexer 214 inserts the data output from the multiplexer 258 between data obtained by down-sampling the data input through the input section 202, in order to supply the inserted data to the intermediate data holding section 218 and the multiplier 226.

In the intermediate data holding section 218, the register r01 holds the data input through the input section 202 and selected by the multiplexer 214 and outputs the data to the multiplexer 220, based on an enable signal (r0en) supplied from the control section 266. Moreover, the register r1 1 holds the data input through the multiplexer 258 and selected by the multiplexer 214 and outputs the data to the multiplexer 220, based on an enable signal (r1en) supplied from the control section 266. Moreover, the register r21 holds the data input through the multiplexer 258 and selected by the multiplexer 214 and outputs the data to the multiplexer 220, based on an enable signal (r2en) supplied from the control section 266.

The multiplexer 220 sequentially selects the data input through the registers r01, r11, and r21 based on a select signal (mbsel) supplied from the control section 266, in order to supply the selected data to the intermediate data holding section 222 and the multiplier 228. In other words, the multiplexer 220 inserts the data input through the register r1 1 between the data input through the register r01 and inserts the data input through the register r21 between the data input through the register r01 and the data input through the register r11, in order to supply the data to the intermediate data holding section 222 and the multiplier 228.

In the intermediate data holding section 222, the register r03 holds the data held in the register r01 and selected by the multiplexer 220 based on the enable signal (r0en) supplied from the control section 266, and outputs it to the multiplexer 224. Moreover, the register r13 holds the data held in the register r11 and selected by the multiplexer 220 based on the enable signal (r1en) supplied from the control section 266, and outputs it to the multiplexer 224. Moreover, the register r23 holds the data held in the register r21 and selected by the multiplexer 220 based on the enable signal (r2en) supplied from the control section 266, and outputs it to the multiplexer 224.

The multiplexer 224 sequentially selects the data input through the registers r03, r13, and r23 based on the select signal (mbsel) supplied from the control section 266, in order to supply the selected data to the multiplier 230. In other words, the multiplexer 224 inserts the data input through the register r13 between the data input through the register r03 and inserts the data input through the register r23 between the data input through the register r03 and the data input through the register r13, in order to supply the data to the multiplier 230.

In other words, the registers r01 and r03 sequentially hold and shift the data input through the A/D 108 and down-sampled by the multiplexer 214 based on the enable signal (r0en). Moreover, the registers r11 and r13 sequentially hold and shift the data down-sampled by the multiplexer 214 and down-sampled by the multiplexer 258 based on the enable signal (r1en). Moreover, the registers r21 and r23 sequentially hold and shift the data down-sampled by the multiplexer 214 and down-sampled by the multiplexer 258 two times, based on the enable signal (r2en).

The multiplier 226 multiplies a filter coefficient h(0) by the data output from the multiplexer 214, i.e., the data down-sampled by the multiplexer 214 or 258, and outputs the result. Moreover, the multiplier 228 multiplies a filter coefficient h(2) by the data down-sampled by the multiplexer 214 or 258 and output from the multiplexer 220, and outputs the result. Moreover, the multiplier 230 multiplies a filter coefficient h(4) by the data down-sampled by the multiplexer 214 or 258 and output from the multiplexer 224, and outputs the result. Moreover, the adder 232 adds the data output from the multiplier 226 and the data output from the multiplier 228, and outputs the added result. Then, the adder 234 adds the data output from the adder 232 and the data output from the multiplier 230, and supplies the added result to the adder 236.

In this manner, the intermediate data holding sections 218 and 222, the multipliers 226, 228, and 230, and the adders 232 and 234 filter the data down-sampled by the multiplexer 214 or 258 to output the data to the adder 236. In addition, in the present embodiment, the arithmetic section 206 has two intermediate data holding sections 218 and 222, three multipliers 226, 228, and 230, and two adders 232 and 234. However, in another embodiment, the arithmetic section 206 may have three or more intermediate data holding sections, four or more multipliers, and three or more adders 232.

On the other hand, in the input selecting section 204, the multiplexer 216 down-samples the data delayed by the register r00 by one sample to supply the result to the intermediate data holding section 238 and multiplier 246 based on the select signal (misel) supplied from the control section 266. In other words, the multiplexer 216 down-samples the data input through the input latch circuit 200 at the timing different from the timing at which the multiplexer 214 down-samples the data input through the input latch circuit 200. Specifically, the multiplexer 216 acquires the data delayed by the register r00 and the data output from the multiplexer 264, and alternately selects the data delayed by the register r00 and the data output from the multiplexer 264 based on the select signal (misel) supplied from the control section 266, in order to supply the selected data to the intermediate data holding section 238 and the multiplier 246. That is, the multiplexer 216 inserts the data output from the multiplexer 264 between data obtained by down-sampling the data delayed by the register r00 to supply the inserted data to the intermediate data holding section 238 and the multiplier 246.

In the intermediate data holding section 238, the register r02 holds the data delayed by the register r00 and selected by the multiplexer 216 and outputs the held data to the multiplexer 240, based on the enable signal (r0en) supplied from the control section 266. Moreover, the register r12 holds the data input through the multiplexer 264 and selected by the multiplexer 216 and outputs the held data to the multiplexer 240, based on the enable signal (r1en) supplied from the control section 266. Moreover, the register r22 holds the data input through the multiplexer 264 and selected by the multiplexer 216 and outputs the held data to the multiplexer 240, based on the enable signal (r2en) supplied from the control section 266.

The multiplexer 240 sequentially selects the data input through the registers r02, r12, and r22 based on the select signal (mbsel) supplied from the control section 266, in order to supply the selected data to the intermediate data holding section 242 and the multiplier 248. That is, the multiplexer 240 inserts the data input through the register r12 between the data input through the register r02 and inserts the data input through the register r22 between the data input through the register r02 and the data input through the register r12, in order to supply the data to the intermediate data holding section 242 and the multiplier 248.

In the intermediate data holding section 242, the register r04 holds the data held in the register r02 and selected by the multiplexer 240 based on the enable signal (r0en) supplied from the control section 266, and outputs it to the multiplexer 244. Moreover, the register r14 holds the data held in the register r12 and selected by the multiplexer 240 based on the enable signal (r1en) supplied from the control section 266, and outputs it to the multiplexer 244. Moreover, the register r24 holds the data held in the register r22 and selected by the multiplexer 240 based on the enable signal (r2en) supplied from the control section 266, and outputs it to the multiplexer 244.

The multiplexer 244 sequentially selects the data input through the registers r04, r14, and r24 based on the select signal (mbsel) supplied from the control section 266, in order to supply the selected data to the multiplier 250. That is, the multiplexer 244 inserts the data input through the register r14 between the data input through the register r04 and inserts the data input through the register r24 between the data input through the register r04 and the data input through the register r14, in order to supply the data to the multiplier 250.

In other words, the registers r02 and r04 sequentially hold and shift the data delayed by the register r00 and down-sampled by the multiplexer 216 based on the enable signal (r0en). Moreover, the registers r12 and r14 sequentially hold and shift the data down-sampled by the multiplexer 216 and down-sampled by the multiplexer 264 based on the enable signal (r1en). Moreover, the registers r22 and r24 sequentially hold and shift the data down-sampled by the multiplexer 216 and down-sampled by the multiplexer 264 two times, based on the enable signal (r2en).

The multiplier 246 multiplies a filter coefficient h(1) by the data output from the multiplexer 216, i.e., the data down-sampled by the multiplexer 216 or 264, and outputs the result. Moreover, the multiplier 248 multiplies a filter coefficient h(3) by the data down-sampled by the multiplexer 216 or 264 and output from the multiplexer 240, and outputs the result. Moreover, the multiplier 250 multiplies a filter coefficient h(5) by the data down-sampled by the multiplexer 216 or 264 and output from the multiplexer 244, and outputs the result. Moreover, the adder 252 adds the data output from the multiplier 246 and the data output from the multiplier 248, and outputs the added result. Then, the adder 254 adds the data output from the adder 252 and the data output from the multiplier 250, and supplies the added result to the adder 236.

In this manner, the intermediate data holding sections 238 and 242, the multipliers 246, 248, and 250, and the adders 252 and 254 filter the data down-sampled by the multiplexer 216 or 264 to output the data to the adder 236. In addition, in the present embodiment, the arithmetic section 206 has two intermediate data holding sections 238 and 242, three multipliers 246, 248, and 250, and two adders 252 and 254. However, in another embodiment, the arithmetic section 206 may have three or more intermediate data holding sections, four or more multipliers, and three or more adders 252.

The adder 236 adds the data output from the adder 234 and the data output from the adder 254, and outputs the added result to the subsequent stage input creating section 208 and the output latch circuit 210.

In the intermediate data holding section 256, the register r05 holds the data held in the registers r01 and r03 among the data output from the adder 236 and outputs the held data to the multiplexers 258 and 260, based on the enable signal (r0en) supplied from the control section 266. The register r15 holds the data held in the registers r11 and r13 among the data output from the adder 236 and outputs the held data to the multiplexers 258 and 260, based on the enable signal (r1en) supplied from the control section 266.

The multiplexer 258 down-samples the data output from the register r05 or rl5 to supply the down-sampled data to the multiplexer 214 based on the select signal (mosel) supplied from the control section 266. In other words, the multiplexer 258 further down-samples the data down-sampled by the multiplexer 214 and filtered by the arithmetic section 206 to supply the result to the multiplexer 214. Specifically, the multiplexer 258 acquires the data output from the register r05 and the data output from the register r15, and sequentially selects the data output from the register r05 and the data output from the register r15 based on the select signal (mosel) supplied from the control section 266, in order to supply the result to the multiplexer 214. That is, the multiplexer 258 inserts the data output from the register r15 between the data obtained by down-sampling the data output from the register r05 in order to supply the result to the multiplexer 214. Moreover, the multiplexer 260 respectively supplies the data output from the registers r05 and r15 to the registers r06 and r16 based on the select signal (mbsel) supplied from the control section 266.

In the intermediate data holding section 262, the register r06 holds the data held in the register r05 among the data output from the multiplexer 260 and delays the held data by one sample in order to outputs the delayed data to the multiplexer 264, based on the enable signal (r0en) supplied from the control section 266. The register r16 holds the data held in the register rl5 among the data output from the multiplexer 260 and delays the held data by one sample in order to output the delayed data to the multiplexer 264, based on the enable signal (r1en) supplied from the control section 266.

The multiplexer 264 down-samples the data output from the register r06 or r16 to supply the down-sampled data to the multiplexer 216 based on the select signal (mosel) supplied from the control section 266. In other words, the multiplexer 264 further down-samples the data down-sampled by the multiplexer 214 and filtered by the arithmetic section 206 to supply the result to the multiplexer 264. Specifically, the multiplexer 264 acquires the data output from the register r06 and the data output from the register r16, and sequentially selects the data output from the register r06 and the data output from the register r16 based on the select signal (mosel) supplied from the control section 266, in order to supply the result to the multiplexer 216. That is, the multiplexer 264 inserts the data output from the register r16 between the data obtained by down-sampling the data output from the register r06 in order to supply the result to the multiplexer 216.

The output latch circuit 210 supplies the data output from the adder 236 to the memory 112 by being supplied with an output enable signal from the control section 266. The output latch circuit 210 may output the data held in the registers r01, r02, r03, and r04, i.e., the data obtained by filtering the data thinned by the multiplexer 214 or 216 one time based on the output enable signal supplied from the control section 266, may output the data held in the registers r11, r12, r13, and r14, i.e., the data thinned by the multiplexer 214 or 216 and then thinned by the multiplexer 258 or 264 one time, or may output the data held in the registers r21, r22, r23, and r24, i.e., the data obtained by filtering the data thinned by the multiplexer 214 or 216 and then thinned by the multiplexer 258 or 264 two times.

In addition, the multiplexers 214, 216, 258, and 264 down-sample data with the same thinning rate. In this way, the same filter coefficient can be multiplied by the data when filtering the data thinned out by the multiplexer 214 or 216 and when filtering the data thinned out by the multiplexer 258 or 264. Therefore, it is possible to loop data to be thinned out and filter the data more than once by means of the same multiplier and adder.

In another example, the intermediate data holding sections 218, 222, 238, and 242 may be realized with a memory. For example, the intermediate data holding sections 218, 222, 238, and 242 may be a dual port memory that receives a writing address or a reading address supplied from the control section 266 to perform the writing or reading of data.

Moreover, in another example, the control section 266 may be realized with a memory. For example, the control section 266 may supply the data stored at addresses designated by a microprogram sequencer to the intermediate data holding section 218, 222, 238, and 242 as an enable signal or an address signal.

Moreover, in another example, the multipliers 226, 228, and 230 can change a filter coefficient, and may filter the data down-sampled by the multiplexer 214 or 258 with a set filter coefficient to output the filtered data. Moreover, the multipliers 246, 248, and 250 can change a filter coefficient, and may filter the data down-sampled by the multiplexer 216 or 264 with a set filter coefficient to output the filtered data.

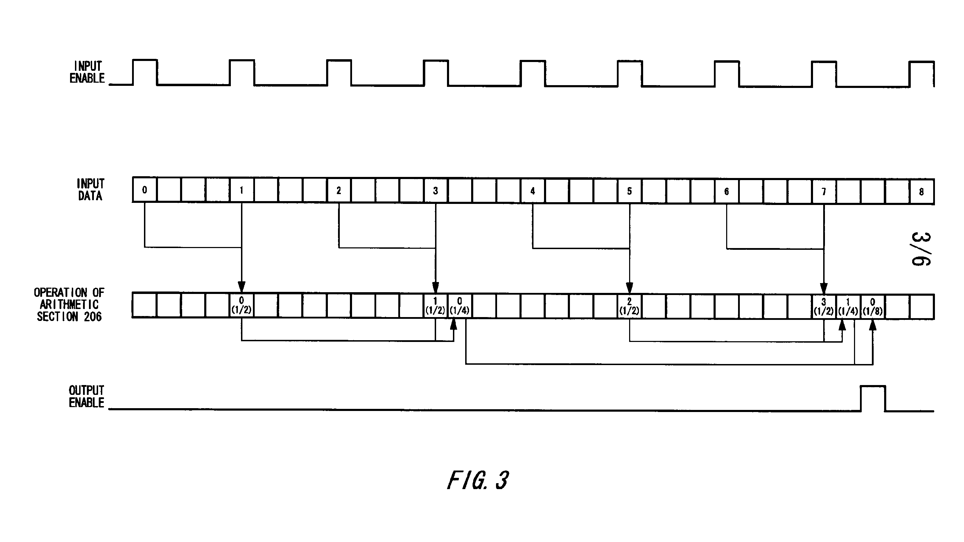

Fig. 3 is a view showing the first example of a timing chart of the thinning filter 110 according to the present embodiment. This example is when the input data are applied from the A/D 108 to the thinning filter 110 at a plurality of clock intervals.

When two input data (0 and 1) are input, the arithmetic section 206 holds the input data in the registers r01 and 03 and the registers r02 and 04 and at the same time filters the data by means of the multipliers 226, 228, and 230 and the multipliers 246, 248, and 250, based on the clock signal (r0en), and obtains one computed result (0(1/2)) of a 1/2 thinning filter. Furthermore, when two input data (2 and 3) are input, the arithmetic section 206 holds the input data in the registers r01 and 03 and the registers r02 and 04 and at the same time filters the data by means of the multipliers 226, 228, and 230 and the multipliers 246, 248, and 250, based on the clock signal (r0en), and obtains one computed result (1(1/2)) of the 1/2 thinning filter.

Then, when two computed results (0(1/2) and 1(1/2)) of the 1/2 thinning filter are obtained, the arithmetic section 206 holds the input data in the registers r11 and 13 and the registers r12 and 14 and at the same time filters the data by means of the multipliers 226, 228, and 230 and the multipliers 246, 248, and 250, based on the next clock signal (r1en) of the clock signal (r0en), and obtains one computed result (0(1/4)) of a 1/4 thinning filter.

Similarly, the arithmetic section 206 obtains one computed result (2(1/2)) of the 1/2 thinning filter from two input data (4 and 5) and obtains one computed result (3(1/2)) of the 1/2 thinning filter from two input data (6 and 7), based on the clock signal (r0en). Then, the arithmetic section 206 obtains one computed result (1(1/4)) of the 1/4 thinning filter from two computed results (2(1/2) and 3(1/2)) of the 1/2 thinning filter, based on the clock signal (r1en).

Then, when obtaining two computed results (0(1/4) and 1(1/4)) of the 1/4 thinning filter, the arithmetic section 206 holds the input data in the registers r21 and 23 and the registers r22 and 24 and at the same time filters the data by means of the multipliers 226, 228, and 230 and the multipliers 246, 248, and 250, based on the next clock signal (r2en) of the clock signal (r1en), and obtains and outputs one computed result (0(1/8)) of a 1/8 thinning filter.

By operating the arithmetic section 206 using the timing chart as described above, it is possible to realize a three-stage thinning filter by repeatedly using one-stage multiplier and adder. Therefore, since a three-stage thinning filter can be realized only by adding a multiplexer, an intermediate data holding section, and a control section to one-stage multiplier and adder, a circuit scale can be reduced.

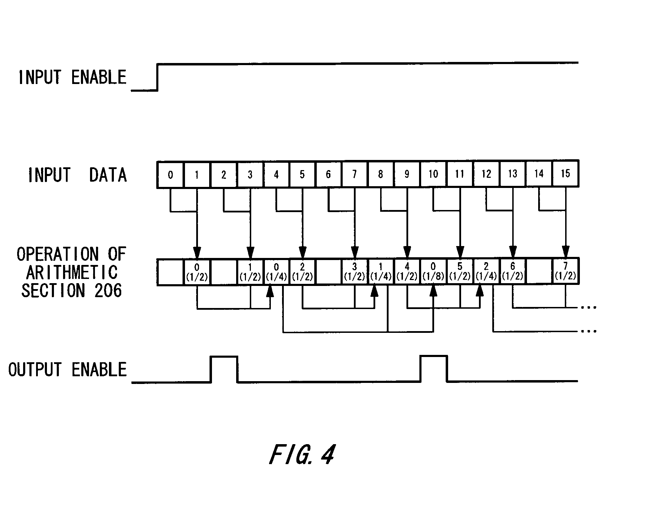

Fig. 4 is a view showing the second example of a timing chart of the thinning filter 110 according to the present embodiment. This example is when the input data are continuously applied from the A/D 108 to the thinning filter 110.

When two input data (0 and 1) are input, the arithmetic section 206 holds the input data in the registers r01 and 03 and the registers r02 and 04 and at the same time filters the data by means of the multipliers 226, 228, and 230 and the multipliers 246, 248, and 250, based on the clock signal (r0en), and obtains one computed result (0(1/2)) of the 1/2 thinning filter. Furthermore, when two input data (2 and 3) are input, the arithmetic section 206 holds the input data in the registers r01 and 03 and the registers r02 and 04 and at the same time filters the data by means of the multipliers 226, 228, and 230 and the multipliers 246, 248, and 250, based on the clock signal (r0en), and obtains one computed result (1(1/2)) of the 1/2 thinning filter.

Then, when two computed results (0(1/2) and 1(1/2)) of the 1/2 thinning filter are obtained, the arithmetic section 206 holds the input data in the registers r11 and 13 and the registers r12 and 14 and at the same time filters the data by means of the multipliers 226, 228, and 230 and the multipliers 246, 248, and 250, based on the next clock signal (r1en) of the clock signal (r0en), and obtains one computed result (0(1/4)) of the 1/4 thinning filter. In addition, the computed result (0(1/4)) of the 1/4 thinning filter is obtained at the timing at which the input data 4 is input.

Moreover, the arithmetic section 206 obtains one computed result (2(1/2)) of the 1/2 thinning filter from two input data (4 and 5) and obtains one computed result (3(112)) of the 1/2 thinning filter from two input data (6 and 7), based on the clock signal (r0en). Then, the arithmetic section 206 obtains one computed result (1(1/4)) of the 1/4 thinning filter from two computed results (2(1/2) and 3(1/2)) of the 1/2 thinning filter, based on the clock signal (r1en) at the timing at which the input data 8 is input.

Then, when obtaining two computed results (0(1/4) and 1(1/4)) of the 1/4 thinning filter, the arithmetic section 206 holds the input data in the registers r21 and 23 and the registers r22 and 24 and at the same time filters the data by means of the multipliers 226, 228, and 230 and the multipliers 246, 248, and 250, based on the next clock signal (r2en) of the clock signal (r1en), and obtains one computed result (0(1/8)) of the 1/8 thinning filter. The computed result (0(1/8)) of the 1/8 thinning filter is obtained at the timing at which the input data 10 is input and is output by turning on the output enable signal at that timing.

By operating the arithmetic section 206 using the timing chart as described above, the arithmetic section 206 can be operated even if the input data are continuously input. Therefore, although the input data having a high data rate are processed, a circuit scale can be reduced.

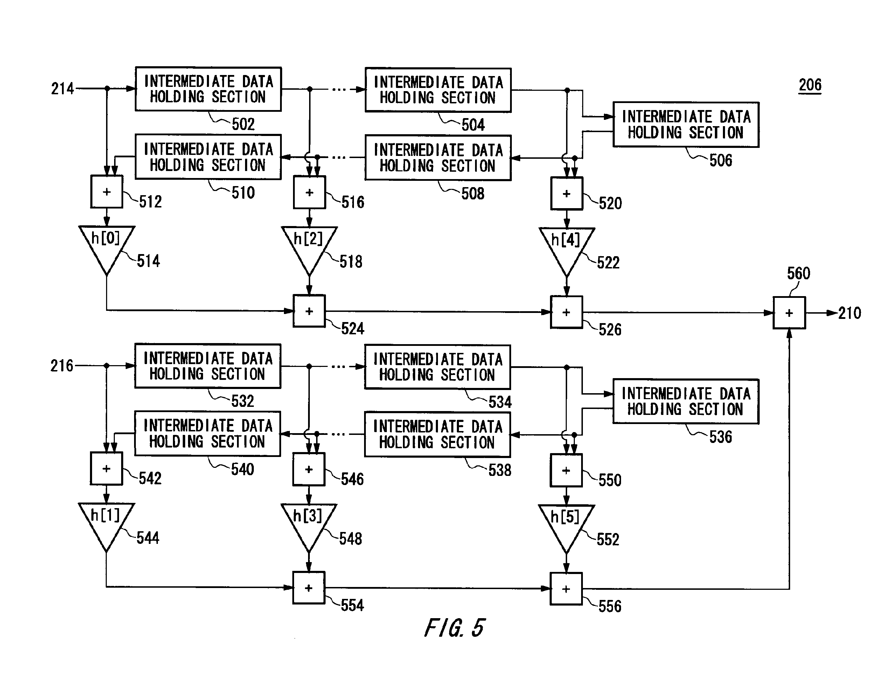

Fig. 5 is a view showing the first alternative example of a configuration of the arithmetic section 206 according to the present embodiment. The arithmetic section 206 according to this alternative example has intermediate data holding sections 502, 504, 506, 508, 510, 532, 534, 536, 538, and 540, adders 512, 516, 520, 524, 526, 542, 546, 550, 554, 556, and 560, and multipliers 514, 518, 522, 544, 548, and 552.

The operations and functions of the intermediate data holding sections 502, 504, 506, 508, 510, 532, 534, 536, 538, and 540 are similar to the operations and functions of the intermediate data holding sections 218, 222, 238, and 242 shown in Fig. 2. The operations and functions of the multipliers 514, 518, 522, 544, 548, and 552 are similar to the operations and functions of the multipliers 226, 228, 230, 246, 248, and 250 shown in Fig. 2. The operations and functions of the adders 524, 526, 554, and 556 are similar to the operations and functions of the adders 232, 234, 252, and 254 shown in Fig. 2. The operations and functions of the adder 236 are similar to those of the adder 560. Therefore, their descriptions will be omitted except for the following description.

The adder 512 adds the data input through the multiplexer 214 and the data output from the intermediate data holding section 510 to supply the added data to the multiplier 514. Then, the multiplier S 14 multiplies the filter coefficient h(0) by the data output from the adder 512 to supply the result to the adder 524. Moreover, the adder 516 adds the data output from the intermediate data holding section 502 and the data output from the intermediate data holding section to supply the result to the multiplier 518. Then, the multiplier 518 multiplies the filter coefficient h(2) by the data output from the adder 516 to supply the added data to the adder 524. Moreover, the adder 520 adds the data output from the intermediate data holding section 504 and the data output from the intermediate data holding section 506 to supply the result to the multiplier 522. Then, the multiplier 522 multiplies the filter coefficient h(4) by the data output from the adder 520 to supply the result to the adder 526.

The adder 542 adds the data input through the multiplexer 216 and the data output from the intermediate data holding section 540 to supply the added data to the multiplier 544. Then, the multiplier 544 multiplies the filter coefficient h(1) by the data output from the adder 542 to supply the result to the adder 554. Moreover, the adder 516 adds the data output from the intermediate data holding section 532 and the data output from the intermediate data holding section to supply the result to the multiplier 548. Then, the multiplier 548 multiplies the filter coefficient h(3) by the data output from the adder 546 to supply the added data to the adder 554. Moreover, the adder 550 adds the data output from the intermediate data holding section 534 and the data output from the intermediate data holding section 536 to supply the result to the multiplier 552. Then, the multiplier 552 multiplies the filter coefficient h(5) by the data output from the adder 550 to supply the result to the adder 556.

That is, the arithmetic section 206 according to this alternative example provides one multiplier for the data output from two intermediate data holding sections, and thus two intermediate data holding sections share one multiplier using subsidiarity of a filter coefficient. Hereby, since the number of multipliers is reduced, it is possible to reduce a circuit scale of the thinning filter 110.

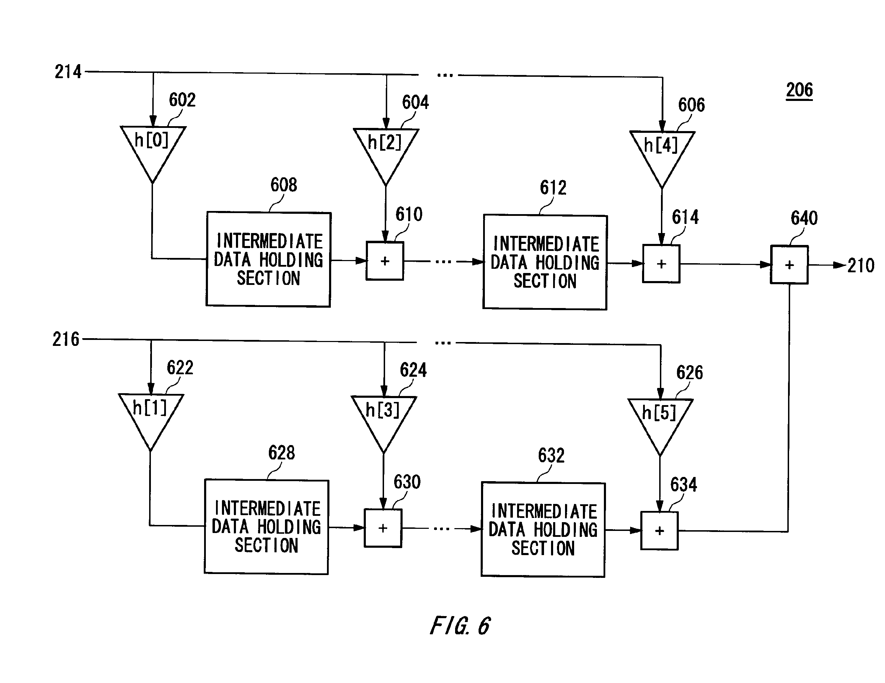

Fig. 6 is a view showing the second alternative example of a configuration of the arithmetic section 206 according to the present embodiment. The arithmetic section 206 according to this alternative example has multipliers 602, 604, 606, 622, 624, and 626, intermediate data holding sections 608, 612, 628, and 632, and adders 610, 614, 630, 634, and 640.

The operations and functions of the multipliers 602, 604, 606, 622, 624, and 626 are similar to the operations and functions of the multipliers 226, 228, 230, 246, 248, and 250 shown in Fig. 2. The operations and functions of the intermediate data holding sections 608, 612, 628, and 632 are similar to the operations and functions of the intermediate data holding sections 218, 222, 238, and 242 shown in Fig. 2. The operations and functions of the adders 610, 614, 630, and 634 are similar to the operations and functions of the adders 232, 234, 252, and 254 shown in Fig. 2. The operations and functions of the adder 640 are similar to those of the adder 560. Therefore, their descriptions will be omitted except for the following description.

The multiplier 602 multiplies the filter coefficient h(0) by the data input through the multiplexer 214 to supply the result to the intermediate data holding section 608. Then, the intermediate data holding section 608 holds the data supplied from the multiplier 602 to output the held data to the adder 610. Moreover, the multiplier 604 multiplies the filter coefficient h(2) by the data input through the multiplexer 214 to supply the result to the adder 610. Then, the adder 610 adds the data supplied from the intermediate data holding section 608 and the data supplied from the multiplier 604 to supply the added data to the intermediate data holding section 612. Moreover, the multiplier 606 multiplies the filter coefficient h(4) by the data input through the multiplexer 214 to supply the result to the adder 614. The adder 614 adds the data supplied from the intermediate data holding section 612 and the data supplied from the multiplier 606 to supply the result to the adder 640.

The multiplier 622 multiplies the filter coefficient h(1) by the data input through the multiplexer 216 to supply the result to the intermediate data holding section 628. Then, the intermediate data holding section 628 holds the data supplied from the multiplier 622 to output the held data to the adder 630. Moreover, the multiplier 624 multiplies the filter coefficient h(3) by the data input through the multiplexer 216 to supply the result to the adder 630. Then, the adder 630 adds the data supplied from the intermediate data holding section 628 and the data supplied from the multiplier 624 to supply the added data to the intermediate data holding section 632. Moreover, the multiplier 626 multiplies the filter coefficient h(5) by the data input through the multiplexer 216 to supply the result to the adder 634. The adder 634 adds the data supplied from the intermediate data holding section 632 and the data supplied from the multiplier 626 to supply the result to the adder 640.

That is, the arithmetic section 206 according to this alternative example has a configuration replacing the arithmetic section 206 with the arithmetic section 206 shown in Fig. 2. According to this, it is possible to shorten a critical path between a register included in one intermediate data holding section and a register included in another intermediate data holding section. In addition, another alternative example may adopt both sides of the sharing of the multiplier shown in Fig. 5 and the replacing configuration shown in Fig. 6.

Although the present invention has been described by way of an exemplary embodiment, it should be understood that those skilled in the art might make many changes and substitutions without departing from the spirit and the scope of the present invention. It is obvious from the definition of the appended claims that embodiments with such modifications also belong to the scope of the present invention.

### INDUSTRIAL APPLICABILITY

As apparent from the above descriptions, according to the present invention, it is possible to provide a thinning filter having a small circuit scale and a high operation rate and a test apparatus including the thinning filter.

## Claims

1. A thinning filter comprising:
a first thinning section for down-sampling input data;
a first filter section for filtering the data down-sampled by said first thinning section to output the filtered data; and
a second thinning section for further down-sampling the data filtered by said first filter section, wherein
said first filter section further filters the data down-sampled by said second thinning section to output the filtered data.

2. The thinning filter as claimed in claim 1, wherein
the thinning filter further comprises:
a third thinning section for down-sampling the input data at the timing different from the timing at which the input data is down-sampled in said first thinning section;
a second filter section for filtering the data down-sampled by said third thinning section with a filter coefficient different from a filter coefficient of said first filter section to output the filtered data; and
a fourth thinning section for further down-sampling the data filtered by said second filter section, and
said second filter section further filters the data down-sampled by said fourth thinning section to output the filtered data.

3. The thinning filter as claimed in claim 2, wherein said first thinning section and said second thinning section down-sample the data with the same thinning rate.

4. The thinning filter as claimed in claim 2, further comprising an adder for adding the data output from said first filter section and the data output from said second filter section.

5. The thinning filter as claimed in claim 4, wherein
the thinning filter further comprises a delaying section for delaying the input data, and
said third thinning section down-samples the data delayed by said delaying section.

6. The thinning filter as claimed in claim 5, wherein
said first thinning section acquires the input data and the data output from said second thinning section and inserts the data output from said second thinning section between the data obtained by down-sampling the input data to supply the inserted data to said first filter section, and
said second thinning section acquires the data delayed by said delaying section and the data output from said fourth thinning section and inserts the data output from said fourth thinning section between the data obtained by down-sampling the data delayed by said delaying section to supply the inserted data to said second filter section.

7. The thinning filter as claimed in claim 1, wherein
said first filter section comprises:
a first multiplier for multiplying a first filter coefficient by the data down-sampled by said first thinning section or said second thinning section to output the result;
a second multiplier for multiplying a second filter coefficient by the data down-sampled by said first thinning section or said second thinning section to output the result; and
an adder for adding the data output from the first multiplier and the data output from the second multiplier.

8. The thinning filter as claimed in claim 1, wherein said first filter section permits the change of filter coefficient, and filters the data down-sampled by said first thinning section or said second thinning section with a set filter coefficient to output the filtered data.

9. A test apparatus that tests a device under test, comprising:
an analog-to-digital conversion section for sampling data output from the device under test to convert the sampled data into digital signal data;
a thinning filter for down-sampling the data output from said analog-to-digital conversion section; and
a quality deciding section for deciding the good or bad of the device under test based on the data down-sampled by said thinning filter, wherein
said thinning filter comprises:
a first thinning section for down-sampling the input data;
a first filter section for filtering the data down-sampled by the first thinning section to output the filtered data; and
a second thinning section for further down-sampling the data filtered by the first filter section, and
the first filter section further filters the data down-sampled by the second thinning section to output the filtered data.
